Europäisches Patentamt

European Patent Office

Office européen des brevets

(11) Veröffentlichungsnummer: **0 175 933**
**A1**

(12) **EUROPÄISCHE PATENTANMELDUNG**

(21) Anmeldenummer: 85110602.1

(22) Anmeldetag: 23.08.85

(51) Int. Cl.⁴: **H01J 37/153** , H01J 37/04 ,
H01J 37/30

(30) Priorität: 21.09.84 DE 3434776

(43) Veröffentlichungstag der Anmeldung:
02.04.86 Patentblatt 86/14

(84) Benannte Vertragsstaaten:
DE FR GB NL

(71) Anmelder: **Siemens Aktiengesellschaft**
**Berlin und München Wittelsbacherplatz 2**
**D-8000 München 2(DE)**

(72) Erfinder: **Plies, Erich, Dr. Dipl.Phys.**
**Deisenhofenerstrasse 79 c**
**D-8000 München 90(DE)**
Erfinder: **Kuck, Gerd, Dr. Dipl.-Phys.**
**Alfred-Schmidt-Strasse 37/IV**
**D-8000 München 70(DE)**

(54) **Rasterlinsen-System ohne Ablenkfarbfehler zur Materialbearbeitung mit Korpuskularstrahlen.**

㉗ Bei einem Rasterlinsen-System für ein Rasterkorpuskularstrahl-Gerät mit Ablenkelementen und mit korpuskularoptischen Linsen soll der Ablenkfarbfehler für beliebige Ablenkwinkel verschwinden und soll das Linsenfeld einer magnetischen Projektionslinse frei von magnetischen Ablenkelementen sein. Dynamisch ablenkende Dipol-Elemente (AE1,AE2, AM1,AM2) sind in Korpuskularstrahlrichtung vor mindestens einer abbildenden Linse (R1,R2) angeordnet. Der isotrope Ablenkfarbfehler der dynamisch ablenkenden Dipol-Elemente (AE1,AE2,AM1,AM2) kompensiert den isotropen Ablenkfarbfehler der mindestens einen abbildenden Linse (R1,R2). Die mindestens eine abbildende Linse (R1,R2) bildet ein verdrehungsfreies System.

FIG 6

EP 0 175 933 A1

Rasterlinsen-System ohne Ablenkfarbfehler zur Materialbearbeitung mit Korpuskularstrahlen.

Die Erfindung betrifft ein Rasterlinsen-System für ein Rasterkorpuskularstrahl-Gerät nach dem Oberbegriff des Anspruchs 1.

Rastert man eine Elektronensonde oder eine Ionensonde mit einem elektrischen oder mit einem magnetischen Ablenksystem über einen Bereich eines Objekts, so wird die Sonde in der Regel proportional zur Ablenkung und proportional zur Energiebreite des Strahles verschmiert. Dieser Ablenkfarbfehler trägt - neben der nicht einfach korrigierbaren Ablenkkoma -wesentlich zur Begrenzung des Rasterfeldes bei Korpuskularstrahl-Maskenschreibern und bei Korpuskularstrahl-Waferschreibern bei.

Es wurden verschiedene Vorschläge zur Korrektur des Ablenkfarbfehlers mittels kombiniert elektrischer und magnetischer Ablenkung gemacht. Beispielsweise ist zu diesem Zweck ein Ablenksystem vorgeschlagen worden, das sich von einem WIEN'schen Filter nur durch die Wahl des Verhältnisses von elektrischer Feldstärke E zu magnetischer Feldstärke B unterscheidet. Beim WIEN'schen Filter wird das Verhältnis E/B gleich der mittleren Teilchengeschwindigkeit v gewählt, so daß die Ablenkung für Teilchen, deren Geschwindigkeit mit der mittleren Teilchengeschwindigkiet v übereinstimmt, verschwindet. Dabei bleibt aber die Dispersion, die einen Ablenkfarbfehler bedingt, endlich. Es ist vorgeschlagen worden, das Verhältnis E/B gleich der halben mittleren Teilschen geschwindigkeit, also gleich v/2, zu wählen. Dabei verschwindet zwar die Dispersion, jedoch verschwindet dafür bei dieser Wahl des Verhältnisses E/B für ein Teilchen, dessen Geschwindigkeit gleich der mittleren Teilchengeschwindigkeit v ist, die Ablenkung nicht.

Aus der US-Patentschrift 4335309 ist ebenfalls ein Vorschlag zur Korrektur des Ablenkfarbfehlers mittels kombiniert elektrischer und magnetischer Ablenkung bekannt. Wird bei Verwendung von hintereinandergeschalteter elektrischer und magnetischer Ablenkung die rein magnetische Ablenkung doppelt so groß und entgegengesetzt gleich der rein elektrischen Ablenkung gewählt, so verschwindet der Ablenkfarbfehler für kleine Ablenkwinkel. Bei diesem Prinzip der hintereinandergeschalteten elektrischen und magnetischen Ablenkung muß das Ablenksystem zur Beibehaltung der Korrektur des Ablenkfarbfehlers im Korpuskularstrahlengang nach der letzten Abbildungslinse angeordnet werden.

Aus IEEE Transactions on Electron Devices ED (1979), 663 ff. ist zur Korrektur des Ablenkfarbfehlers die Anordnung eines magnetischen Ablenkelements im Feld einer magnetischen Projektionslinse bekannt. Da durch die Anordnung eines einzigen magnetischen Ablenkelements im Feld einer magnetischen Projektionslinse nur der isotrope, nicht aber der anisotrope Anteil des Ablenkfarbfehlers korrigiert werden kann, wird im Feld dieser magnetischen Projektionslinse zusätzlich noch ein zweites, gegenüber dem ersten magnetischen Ablenkelement gedrehtes magnetisches Ablenkelement vorgeschlagen.

Der vorliegenden Erfindung liegt die Aufgabe zugrunde, ein Rasterlinsen-System der eingangs genannten Art anzugeben, bei dem der Ablenkfarbfehler für beliebige Ablenkwinkel ver schwindet und bei der das Linsenfeld einer magnetischen Projektionslinse frei von magnetischen Ablenkelementen sein kann.

Diese Aufgabe wird erfindungsgemäß durch ein Rasterlinsen-System nach dem Anspruch 1 gelöst. Ausgestaltungen und Vorteile der Erfindung sind in den Unteransprüchen, der Beschreibung und der Zeichnung dargestellt.

Ein Rasterlinsen-System nach der Erfindung besteht aus dynamisch ablenkenden Dipol-Elementen und aus abbildenden Rundlinsen. Das Korrekturprinzip beruht dabei auf der Kompensation des isotropen Ablenkfarbfehlers, den die Dipol-Elemente aufgrund der Dispersion aufweisen, durch den isotropen Ablenkfarbfehler von Rundlinsen, der bei den Rundlinsen aufgrund der Farbabhängigkeit der Vergrößerung entsteht, und auf einer gleichzeitigen Vermeidung des anisotropen Ablenkfarbfehlers bei den Rundlinsen, der aus der Farbabhängigkeit einer Bilddrehung resultieren könnte, dadurch, daß verdrehungsfreie Systeme verwendet werden.

Zur Kompensation des isotropen Ablenkfarbfehlers werden ein oder mehrere dynamisch ablenkende Dipol-Felder im Korpuskularstrahlengang vor der letzten Rundlinse bzw. vor dem letzren Rundlinsen-Duplett so angeordnet, daß der Pivotpunkt, der bei einstufiger Ablenkung gleich dem Ablenkhauptpunkt ist, korrekturgünstig liegt. Dann tritt das abgelenkte Korpuskularstrahlbündel durch die Außenzone der Rundlinse und wird zur geraden optischen Achse hingelenkt. Für die Rundlinse scheint das Korpuskularstrahlbündel aufgrund der Vorablenkung von einem außeraxialen Punkt der Gegenstandsebene zu kommen, so daß - im Gegensatz zu einer Ablenkung, die im Strahlengang gesehen erst nach der Linse erfolgt - die außeraxialen Farbfehler der Rundlinse zum gesamten Ablenkfarbfeh ler beitragen. Die isotropen Ablenkfarbfehler von Dipol-Element und von Rundlinse haben entgegensetztes Vorzeichen, da die Krümmungen der Korpuskularstrahl-Bündelachse in den beiden Elementen, nämlich in Dipol-Element und in Rundlinse, entgegengesetzt sind und da zwischen den beiden Elementen kein Zwischenbild liegt. Mit den drei Koordinaten der Gegenstandsebene, des Pivotpunktes und der Bildebene auf der optischen Achse und mit der Wahl der Rundlinsenstärke stehen genügend Parameter zur Verfügung, um eine vollständige Kompensation der verschiedenen Beiträge zum Gesamtablenkfarbfehler zu erreichen.

Der anisotrope Anteil des Gesamtablenkfarbfehlers verschwindet, wenn die der dynamischen Ablenkung folgende Linse bzw. folgendes Linsensystem verdrehungsfrei ist. Dies ist beispielsweise dann der Fall, wenn die der dynamischen Ablenkung folgende Linse bzw. Linsensystem entweder rein elektrisch wirkt oder ein verdrehungsfreues magnetisches Duplett ist.

Wesentlich ist also, daß das der dynamischen Ablenkung folgende Linsensystem verdrehungsfrei ist und daß zwischen der dynamischen Ablenkung und dem Linsensystem kein Zwischenbild liegt.

Die dynamische Ablenkung kann beispielsweise zweistufig magnetisch sein, zweistufig elektrisch sein oder auch zweistufig magnetisch für eine langsame Hauptablenkung, und zusätzlich zweistufig elektrisch für eine schnelle kleine Zusatzablenkung sein. Daneben sind weitere Beispiele für die dynamische Ablenkung vor dem letzten Linsensystem denkbar. Wesentlich dabei ist, daß der isotrope Ablenkfarbfehler von Dipol-Elementen und der isotrope Ablenkfarbfehler von Rundlinsen sich gegenseitig kompensieren.

Als Korpuskularstrahl-Geräte kommen sowohl Elektronenstrahl-Geräte als auch Ionenstrahl-Geräte in Betracht.

Ausführungsbeispiele der Erfindung werden im folgenden anhand der Zeichnung näher beschrieben.

Fig.1 erläutert ein Rasterlinsen-System mit Vorablenkung nach der Erfindung.

Fig.2 mit 6 erläutern Ausführungsbeispiele eines Rasterlinsen-Systems nach der Erfindung.

Fig.7 erläutert den Verdrehungsfarbfehler für Rundlinsen.

$$W_1 = A_F \ W_1 \ \frac{\Delta U}{U} \quad , \qquad \qquad (1)$$

$$mit \ . A_F = - \frac{W_E + W_M/2}{W_E + W_M} + C_F^V + i \ C_F^D$$

In Gleichung (1) bdeuten
$\Delta W_i$ ..... den komplexen Bildfehler,
$A_F$ ...... die komplexe Ablenkfarbfehler-Konstante,
$U$ ....... die Beschleunigungsspannung der Korpuskeln,
$\Delta U$ ...... die (halbe) Energiebreite der Korpuskeln,
$W_i = W_E + W_M$ die Gauß'sche Ablenkung in der Bildebene und
$C_F^V, C_F^D..$ die beiden (reellen) außeraxialen Farbfehler-Konstanten der Rundlinse R bzw. des Rundlinsen-Systems R1, R2.
$C_F^V$ ..... beschreibt die Farbabhängigkeit der Vergrößerung und
$C_F^D$ ..... beschreibt die Farbabhängigkeit der Bilddrehung.

Für die Farbfehler-Konstante $C_F^V$ ist derjenige Koeffizient zu verwenden, der sich für die Rundlinse R, bzw. für das Rundlinsen-System $R_1$, $R_2$ zusammen mit Blende ergibt, und zwar auch dann, wenn keine Blende vorhanden ist, denn aufgrund der Vorablenkung schneidet die Korpuskularstrahl-Bündelachse die gerade optische Achse OA im Pivotpunkt $z_p$, was ohne Vorablenkung dem Vorhandensein einer Aperturblende beim Pivotpunkt bei der Koordinate $z_p$ auf der optischen Achse OA entspricht. Die Farbfehler-Konstante $C_F^D$ ist unabhängig von der Blendenlage.

$z_0$ ist die Koordinate der Gegenstandsebene und $z_i$ ist die Koordinate der Bildebene. AE1, AE2 sind elektrische Ablenkelemente, die im einfachsten Fall aus symmetrisch zur optischen Achse OA angeordneten Kondensatorplatten bestehen, wobei die symmetrisch zur optischen Achse OA angeordneten Kondensatorplatten mit Spannungen versorgt werden, die denselben Betrag, aber entgegengesetztes Vorzeichen aufweisen. AM1, AM2 sind magnetische Ablenkelemente, R1, R2 sind Rundlinsen.

Die Vorablenkung der Korpuskeln kann einstufig elektrisch, zweistufig elektrisch. mehrstufig elektrisch, einstufig magnetisch, zweistufig magnetisch, mehrstufig magnetisch sowie gemischt einstufig oder mehrstufig elektrisch und einstufig oder mehrstufig magnetisch sein.

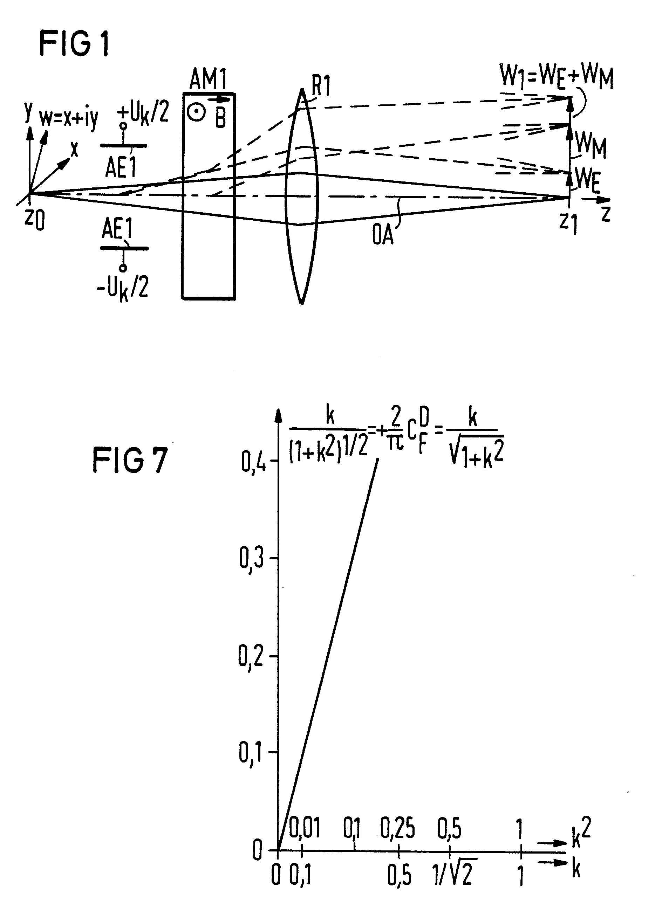

Fig.1 erläutert das Prinzip für ein Rasterlinsen-System mit Vorablenkung nach der Erfindung. Für ein Rasterlinsen-System mit magnetischer und/oder elektrischer Vorablenkung, wie beispielsweise in den Fig.1 mit 6 abgebildet, kann man den Ablenkfarbfehler mit Hilfe folgender Formeln berechnen:

Das Rundlinsen-System kann entweder rein elektrisch oder ein verdrehungsfreies magnetisches Duplett sein, oder aus einer Kombination von elektrischen und magnetischen Rundlinsen bestehen, die in ihrer Gesamtheit verdrehungsfrei sind und die so angeordnet sind, daß zwischen den einzelnen Elementen von Vorablenkungs-System und Rundlinsen-System kein Zwischenbild vorhanden ist.

Die komplexe Variable w zur Beschreibung der Ablenkung des Korpuskularstrahls ist definiert als $w = x + iy$.

Fig.1 zeigt ein Rasterlinsen-System mit einem einstufigen elektrischen Ablenkelement AE1, mit einem einstufigen magnetischen Ablenkelement AM1 und mit einer einzelnen elektrischen Rundlinse R1. Die Ablenkplatten des Ablenkelements AE1 haben die Spannung $\pm U_K/2$.

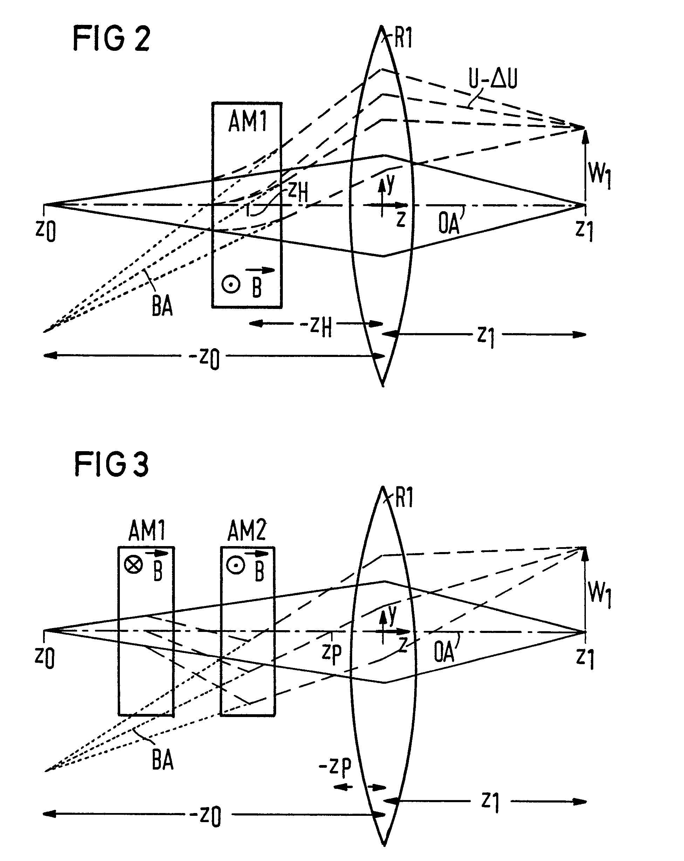

Fig.2 zeigt ein Rasterlinsen-System mit einem einstufigen magnetischen Ablenkelement AM1 und mit einer einstufigen elektrischen Rundlinse R1.

Fig.3 zeigt ein zweistufiges System zur Vorablenkung mit den beiden magnetischen Ablenkelementen AM1, AM2 und mit einer einzelnen elektrischen Rundlinse R1. In diesen beiden Figuren 2, 3 ist eingezeichnet, wie die Korpuskularstrahl-Bündelachse BA aufgrund der Vorablenkung die gerade optische Achse OA im Pivotpunkt mit der Koordinate $z_p$ schneidet, was ohne Vorablenkung dem Vorhandensein einer Aperturblende bei der Koordinate $z_p$ entspricht. Da in Fig.2 nur eine einstufige Vorablenkung vorhanden ist, entspricht der Pivotpunkt dem Ablenkhauptpunkt, der an der Koordinate $z_H$ angeordnet ist.

Die Korpuskularstrahl-Bündelachse BA entspricht derjenigen Achse, entlang welcher diejenigen Korpuskeln sich bewegen, die auf der optischen Achse OA zentral auf das Rasterlinsen-System sich zu bewegen und dabei die Energie U haben. In Fig.2 ist zusätzlich derjenige Bahnverlauf eingezeichnet, dem entlang sich solche Teilchen bewegen, die zwar ebenfalls auf der optischen Achse zentral sich auf das Rasterlinsen-System zu bewegen, dabei jedoch eine Energie U-$\Delta$U aufweisen. Diese Bahn ist in Fig.2 mit U-$\Delta$U bezeichnet.

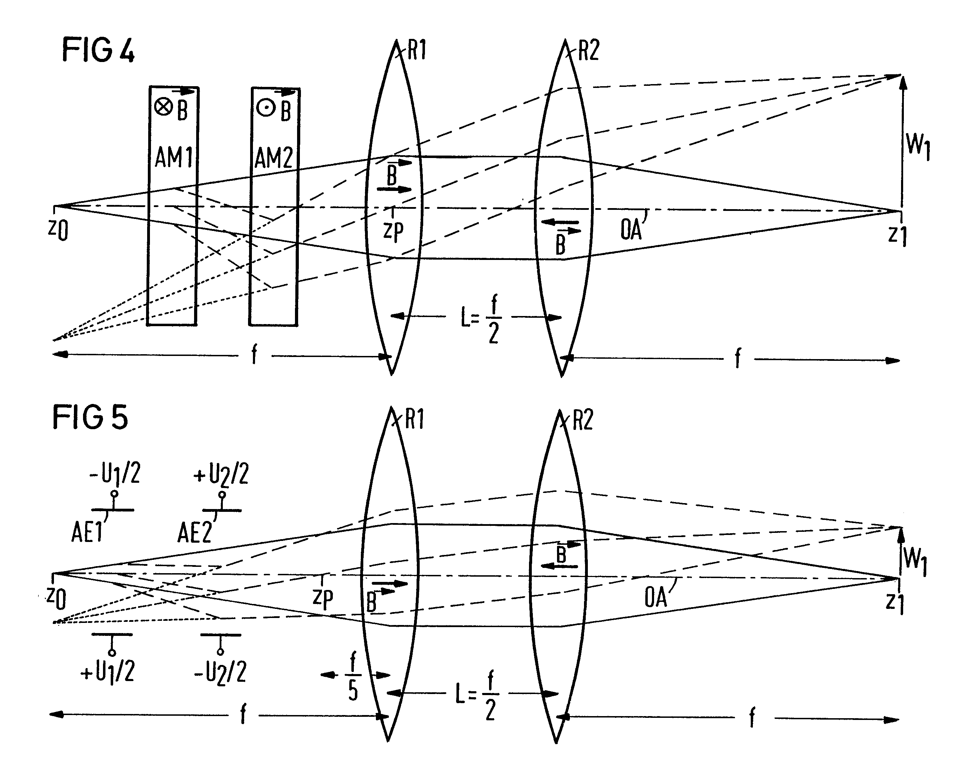

Fig.4 zeigt ein Rasterlinsen-System mit zweistufiger magnetischer Vorablenkung und mit einem verdrehungfreien magnetischen Rundlinsen-Duplett. Die Vorablenkung erfolgt an den beiden magnetischen Ablenkelementen AM1, AM2. Das magnetische Rundlinsen-System besteht aus den beiden Rundlinsen R1, R2. Für das Rasterlinsen-System nach Fig.4 vereinfacht sich der Ablenkfarbfehler-Koeffizient zu

$$A_F = - \frac{1}{2} + C_F{}^V + i\,C_F{}^D \qquad (2)$$

Der Verdrehungsfarbfehler des magnetischen Rundlinsen-Dubletts kann folgendermaßen geschrieben werden:

$$C_F{}^D = + \left\{ \frac{k_1}{(1+k_1{}^2)^{1/2}} + \frac{k_2}{(1+k_2{}^2)^{1/2}} \right\} \cdot \frac{\pi}{2}$$

$$\approx + \frac{\pi}{2}(k_1+k_2) \quad \text{für kurze schwache Linsen,} \qquad (3)$$

wobei $k_1{}^2$ und $k_2{}^2$ die Linsenstärken der beiden Duplett-Linsen R1, R2 sind und wobei man mit Hilfe der Erregungen $N_1 I_1$ und $N_2 I_2$ schreiben kann:

$$k_i{}^2 = 0{,}00352 \cdot \frac{(N_i I_i / A)^2}{U^*/V} \quad ; \quad i = 1,2 \qquad (4)$$

Die Erregungen $N_1 I_1$ und $N_2 I_2$ sind in dieser Gleichung in Ampere einzutragen, die Beschleunigungsspannung $U^*$ ist in Volt einzutragen. Die Beschleunigungsspannung $U^*$ erhält man dann, wenn man die Energie der Korpuskeln durch deren Ladung teilt und davon den Absolutwert nimmt.

Aus Gleichung (3) und aus Fig.7 ersieht man direkt, daß der Koeffizient $C_F{}^D$ des Dupletts verschwindet, wenn die beiden Einzellinsen R1, R2 entgegengesetzt, aber gleich stark erregt sind:

$$k_1 = -k_2$$

$$(5)$$

Für den Vergrößerungsfarbfehler des Dupletts erhält man -wenn man wiederum wie beim Koeffizienten $C_F{}^D$ Glaser'sche Glockenfelder verwendet - :

$$C_F^{\,V} = \frac{\pi}{2}\left\{ \frac{k_1^{\,2}}{\omega_1^{\,2}} \cot \omega_1 (\varphi_0 - \varphi_P) + \frac{k_2^{\,2}}{\omega_2^{\,2}} \cot \omega_2 (\tilde{\varphi}_0 - \tilde{\varphi}_P) \right\}$$

$$\text{mit } \omega_i = \sqrt{1+k_i^{\,2}} \quad , \ i = 1,2 \ ;$$

$d_i = $ halbe Halbwertsbreite des Glaser'schen Glockenfeldes, $i = 1,2$ ;

$$\cot \tilde{\varphi}_P = \left\{ d_1 \cot \left( \varphi_P - \frac{\pi}{\omega_1} \right) - L \right\} / d_2 \ ;$$

$$\cot \tilde{\varphi}_0 = \left\{ d_1 \cot \left( \varphi_0 - \frac{\pi}{\omega_1} \right) - L \right\} / d_2 \ ;$$

$$\cot \varphi_0 = z_0 / d_1 \ ;$$

$$\cot \varphi_P = z_P / d_1 \ ;$$

$z_0 = $ Koordinate der Gegenstandsebene;

$z_P = $ Koordinate des Pivotpunktes;

$L = $ Abstand der Mitten der Duplett-Linsen R1, R2.

$$\quad\quad\quad\quad\quad\quad\quad\quad\quad\quad\quad\quad (6)$$

Legt man die Gegenstandsebene mit der Koordinate $z_0$ wie in Fig.4 gezeichnet, in die vordere Brennebene der ersten Duplett-Linse R1 und nimmt weiterhin beide Linsen R1, R2 als schwach an, so gilt dann, wenn die Brennweite der beiden Linsen R1, R2 gleich der Brennweite f ist:

$$C_F^{\,V} = - \frac{2\, z_P}{z_P + f} + \frac{L}{f} \quad\quad\quad (7)$$

Zur Korrektur des isotropen Ablenkfarbfehlers (Realteil von $A_F$) muß der Koeffizient $C_F^{\,V}$ gleich 1/2 sein, was man beispielsweise durch das Wertepaar:

$$z_P = 0 \ \text{und} \ L/f = 0,5$$

$$(8)$$

erreichen kann. Dieses als Beispiel angenommene Wertepaar nach Gleichung (8) ist in Fig.4 dargestellt. Es gibt einen ganzen Bereich von Wertepaaren $z_P/f$, $L/f$, die die Korrekturbedingung, nämlich daß der Koeffizient $C_F^{\,V}$ gleich 1/2 sein muß, erfüllen. Weil der Abstand L der Mitten der beiden Linsen R1, R2 größer als O ist, kommen aber nur Pivotpunkte in Betracht, deren Koordinate $z_P$ größer als -f/5 ist. Sehr große Abstände L zwischen den beiden Linsen R1, R2 scheiden aus technischen Gründen aus.

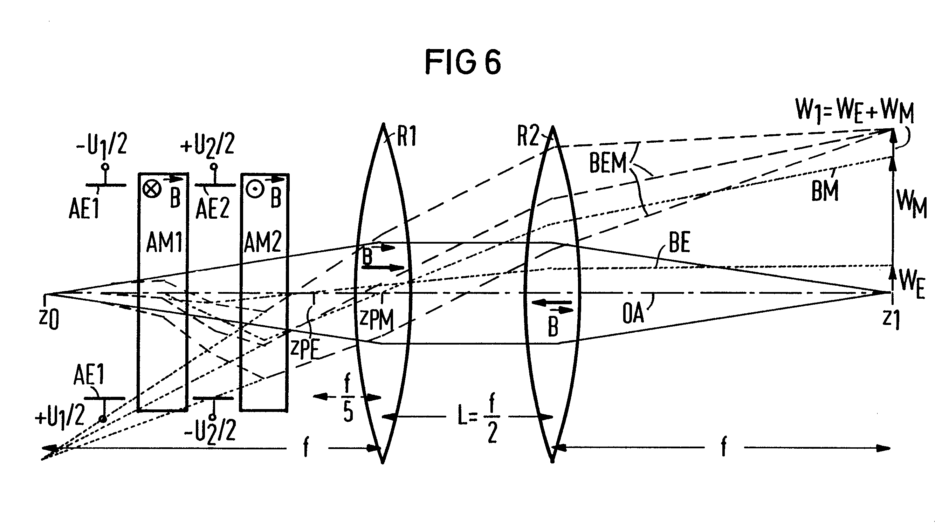

Fig.5 zeigt ein Rasterlinsen-System mit zweistufiger elektrischer Vorablenkung und mit einem verdrehungsfreien magnetischen Rundlinsen-Duplett. Das zweistufige elektrische Vorablenkungs-System weist dabei die beiden Ablenkelemente AE1 und AE2 auf. Das Rundlinsen-Duplett besteht wiederum aus zwei magnetischen Linsen R1, R2. Bei rein elektrischer Ablenkung vereinfacht sich Gleichung (1) zu

$$A_F = -1 + C_F^{\,V} + i\, C_F^{\,D}$$

$$(9)$$

Bei dem Beispiel nach Fig.5 wird dasselbe Rundlinsen-Duplett wie bei dem Ausführungsbeispiel nach Fig.4 verwendet. Auch bei dem Ausführungsbeispiel nach Fig.5 ist der Koeffizient $C_F^{\,D}$, der den Verdrehungsfarbfehler beschreibt, gleich 0. Zur Korrektur des isotropen chromatischen Ablenkfehlers muß also der Koeffizient $C_F^{\,V}$ gleich 1 sein. Diese Forderung liefert zusammen mit Gleichung (7) und mit dem aus Fig.4 übernommenen Werte Beispiel $L/f = 0,5$ für den Pivotpunkt die Koordinate $z_P = -f/5$. Außer diesem Beispiel für das Wertepaar:

$$Z_P = -f/5 \ \text{und} \ L/f = 0,5$$

$$(10)$$

existiert auch bei einem Rasterlinsen-System nach Fig.5 ein zweidimensionales Wertebereich zur Korrektur des isotropen Ablenkfarbfehlers (Realteil von $A_F$), genauso wie bei dem Ausführungsbeispiel nach Fig.4, aber weil auch nach dem Ausführungsbeispiel nach Fig.5 der Abstand L der

Mitten der beiden Duplett-Linsen R1, R2 größer als O ist, ist auch beim Ausführungsbeispiel nach Fig.5 der zweidimensionale Wertbereich darauf eingeschränkt, daß die Koordinate $z_p$ des Pivotpunktes größer als -f/3 ist.

Fig.6 zeigt ein Rasterlinsen-System für langsame magnetische Hauptablenkung und für schnelle elektrische Zusatzablenkung. Das Vorablenkungs-System ist dabei so aufgebaut, daß in Korpuskularstrahlrichtung zuerst ein elektrisches Ablenkelement AE1, sodann ein magnetisches Ablenkelement AM1, sodann wieder ein elektrisches Ablenkelement AE2 und schließlich wiederum ein magnetisches Ablenkelement AM2 angeordnet sind. Die Pivotpunkte $z_{pM}$, $z_{pE}$ für die rein magnetische bzw. für die rein elektrische Ablenkung sind so gewählt, daß der isotrope Ablenkfarbfehler (Realteil von $A_F$) gleich O ist für rein magnetische bzw. rein elektrische Ablenkung. Wird gemischt, d.h. sowohl magnetisch als auch elektrisch, abgelenkt, so ist der Realteil von $A_F$ nicht mehr vollständig gleich 0. Ist die elektrische Ablenkung klein gegen die magnetische Ablenkung, so bleibt ein Rest mit

$$A_F \approx - \frac{1}{2} \left\{ \frac{W_E}{W_M} - \left( \frac{W_E}{W_M} \right)^2 \right\} \qquad (11)$$

Wenn der Absolutbetrag der rein elektrischen Ablenkung $W_E$ kleiner ist als 1/10 des Absolutbetrags der rein magnetischen Ablenkung $W_M$, wenn die Beschleunigungsspannung U für Elektronen gleich 20 kV ist, wenn die (halbe) Energiebreite U des Elektronenstrahlbündels gleich 5 Volt ist und wenn der Absolutbetrag des komplexen Bildfehlers $W_i$ kleiner als 0,05 µm ist, erhält man mit den Gleichungen (11) und (1) in der Rasterebene eine erlaubte Auslenkung (Absolutbetrag von $W_i$) von weniger als 4 mm, d.h. es kann ein quadratischer Bereich von 5,6 $\times$ 5,6 mm2 mit Ablenkfarbfehler (gleich 2 mal dem Absolutwert von $W_i$) von unter 0,1 µm ausgerastert werden. Ein solches System nach Fig.6 kann also in hervorragender Weise den jeweiligen Anforderungen für beispielsweise einen schnellen Elektronenstrahlschreiber angepaßt werden.

In Fig.6 ist mit BE die Bündel-Achse eines rein elektrisch abgelenkten Elektronenstrahlbündels, mit BM die Bündel-Achse eines rein magnetisch abgelenkten Elektronenstrahlbündels und mit BEM ein elektrisch und magnetisch abgelenktes Elektronenstrahlbündel bezeichnet.

Fig.7 erläutert den Verdrehungsfarbfehler des magnetischen Glaser'schen Glockenfeldes, wie er in Gleichung (3) verwendet worden ist. Der den Verdrehungsfarbfehler bezeichnende Koeffizient $C_F^D$ wächst monoton und geht für große Werte von k asymptotisch gegen $\pi/2$.

Die abbildenden Linsen R1, R2 müssen nicht unbedingt Rundlinsen sein. Nur das gesamte abbildende Linsensystem in Korpuskularstrahlrichtung nach dem Ablenksystem muß insgesamt verdrehungsfrei sein. Jede Kombination von Linsen R1, R2 u.s.w., die ein verdrehungsfreies Linsensystem bildet, ist für ein Ausführungsbeispiel nach der Erfindung verwendbar.

## Ansprüche

1. Rasterlinsen-System für ein Rasterkorpuskularstrahl-Gerät mit Ablenkelementen und mit korpuskularoptischen Linsen, dadurch **gekennzeichnet,** daß die dynamisch ablenkenden Dipol-Elemente (AE1, AE2, AM1, AM2) in Korpuskularstrahlrichtung vor mindestens einer abbildenden Linse (R1,R2) angeordnet sind, wobei der isotrope Ablenkfarbfehler der dynamisch ablenkenden Dipol-Elemente (AE1, AE2, AM1, AM2) den isotropen Ablenkfarbfehler der mindestens einen abbildenden Linse (R1,R2) kompensiert und wobei die mindestens eine abbildende Linse (R1,R2) ein verdrehungsfreies System bildet.

2. Rasterlinsen-System nach Anspruch 1, dadurch **gekennzeichnet,** daß die mindestens eine abbildende Linse (R1,R2) als Rundlinse ausgebildet ist.

3. Rasterlinsen-System nach Anspruch 1 oder 2, **gekennzeichnet** durch eine elektrische Linse als abbildende Linse.

4. Rasterlinsen-System nach einem der Ansprüche 1 bis 3, **gekennzeichnet** durch ein verdrehungsfreies magnetisches Duplett (R1,R2) als abbildende Linsen.

5. Rasterlinsen-System nach einem der Ansprüche 1 bis 4, **gekennzeichnet** durch mindestens ein elektrisches Ablenkelement (AE1,AE2).

6. Rasterlinsen-System nach einem der Ansprüche 1 bis 5, **gekennzeichnet** durch mindestens ein magnetisches Ablenksystem (AM1,AM2).

7. Rasterlinsen-System nach einem der Ansprüche 1 bis 6, **gekennzeichnet** durch magnetische Ablenkelemente (AM1,AM2) zur langsamen Hauptablenkung und durch elektrische Ablenkelemente (AE1,AE2) zur schnellen Zusatzablenkung.

# FIG 1

# FIG 7

$$\frac{k}{(1+k^2)^{1/2}} = +\frac{2}{\pi} C_F^D = \frac{k}{\sqrt{1+k^2}}$$

# FIG 2

# FIG 3

FIG 4

FIG 5

# FIG 6

0 175 933

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| P,Y | US-A-4 475 044 (KURODA et al.)<br>* Figur 2; Spalten 2,3 * | 1 | H 01 J 37/153<br>H 01 J 37/04<br>H 01 J 37/30 |
| Y | PROCEEDINGS OF THE SYMPOSIUM ON ELECTRON AND ION BEAM SCIENCE AND TECHNOLOGY, 8th international conference, Band 78, Nr. 5, Seiten 32-43, Princeton, New Jersey, US; W. STICKEL et al.: "Optics of a variable shaped electron beam column"<br>* Seiten 33,34; Figur 3: Seite 41 * | 1,2 | |
| A | PATENTS ABSTRACTS OF JAPAN, Band 5, Nr. 141 (E-73)[813], 5. September 1981; & JP - A - 56 78051 (NIPPON DENSHI K.K.) 26.6.1981 | 1 | |
| A | DD-C- 126 382 (VEB CARL ZEISS JENA)<br>* Seite 3, Zeile 15 - Seite 6, Zeile 29; Figur 1 * | 1 | RECHERCHIERTE SACHGEBIETE (Int. Cl.4)<br><br>H 01 J 37 |
| A | FR-A-2 415 348 (VEB CARL ZEISS JENA)<br>* Seite 3, Zeile 37 - Seite 6, Zeile 25; Seite 12, Zeile 35 - Seite 16, Zeile 5; Figur 5 * | 1,4,6 | |

-/-

Der vorliegende Recherchenbericht wurde für alle Patentansprüche erstellt.

| Recherchenort | Abschlußdatum der Recherche | Prüfer |
|---|---|---|
| DEN HAAG | 13-12-1985 | SCHAUB G.G. |

## EUROPÄISCHER RECHERCHENBERICHT

Europäisches
Patentamt

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | DE-A-2 937 004 (FRAUNHOFER GESELLSCHAFT) <br> * Seite 6, Absätze 2,3; Seite 9, letzter Absatz; Figuren * <br><br> ----- | 1 | |
| | | | RECHERCHIERTE SACHGEBIETE (Int. Cl.4) |

Der vorliegende Recherchenbericht wurde für alle Patentansprüche erstellt.

| Recherchenort | Abschlußdatum der Recherche | Prüfer |
|---|---|---|
| DEN HAAG | 13-12-1985 | SCHAUB G.G. |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82